# EUROPÄISCHE PATENTSCHRIFT

(11) **EP 0 387 623 B1**
(45) Veröffentlichungstag und Bekanntmachung des Hinweises auf die Patenterteilung: **23.04.1997**
(21) Anmeldenummer: 90104009.7
(22) Anmeldetag: 01.03.1990
(51) Int. Cl.: G03F 7/004

(54) **Positiv arbeitendes strahlungsempfindliches Gemisch und daraus hergestelltes strahlungsempfindliches Aufzeichnungsmaterial für hochenergetische Strahlung**
Positive-working radiation-sensitive composition and radiation-sensitive recording material for use with high-energy radiation prepared therefrom
Mélange positif photosensible et matériau photosensible pour l'enregistrement des radiations de haute énergie

(30) Priorität: 11.03.1989 DE 3907954
(43) Veröffentlichungstag der Anmeldung: 19.09.1990
(73) Patentinhaber: HOECHST AKTIENGESELLSCHAFT, 65926 Frankfurt am Main (DE)
(72) Erfinder: Dammel, Ralph, Dr., Dipl.-Chem., D-6501 Klein-Winternheim (DE); Lingnau, Jürgen, Dr., Dipl.-Chem., D-6500 Mainz-Laubenheim (DE); Pawlowski, Georg, Dr., Dipl.-Chem., D-6200 Wiesbaden (DE); Theis, Jürgen, Dr., Dipl.-Phys., D-6000 Frankfurt 1 (DE)

(56) Entgegenhaltungen:
- EP-A- 0 232 972
- FR-A- 2 389 155

## Beschreibung

Die Erfindung betrifft ein positiv arbeitendes strahlungsempfindliches Gemisch, enthaltend eine Verbindung, die unter Einwirkung von hochenergetischer Strahlung eine Säure bildet sowie eine Verbindung, die durch Säure spaltbar ist.

Bei der klassischen UV-Lithographie ist die Grenze der Auflösung durch die Wellenlänge der verwendeten Strahlung vorgegeben. Die stetige Verkleinerung der Dimensionen bei der Chip-Herstellung erfordert daher im Submikronbereich neue Lithographietechniken, wobei wegen ihrer extrem kurzen Wellenlänge Elektronen- oder Röntgenstrahlung eingesetzt werden. Dabei hat sich gezeigt, daß Resistmaterialien, die als Elektronenstrahlresist geeignet sind, auch als Röntgenstrahlresist eingesetzt werden können und umgekehrt.

Bekannte Resistmaterialien für diese Anwendung sind Acrylate und Methacrylate (G.M. Taylor, Solid State Technology, 124 (1984)). Bei diesen Materialien zeigte sich, daß Empfindlichkeit und Strukturauflösung meist gegenläufige Eigenschaften sind. Sollen höhere Empfindlichkeiten erreicht werden können, werden meist Halogene in den Resist eingebaut. Dabei wird in positiv arbeitenden Resists meist Fluor und Chlor, in negativ arbeitenden Resists dagegen neben Chlor eher Brom und Iod eingesetzt (T. Yamaoka et al., Phot. Sci. Eng. 23, 196 (1979)).

Im allgemeinen zeigen negativ arbeitende Resists eine höhere Empfindlichkeit als positiv arbeitende, können dagegen aber nicht - wie oben ausgeführt - gleichzeitig eine hohe Auflösung im Submikronbereich aufweisen. Andererseits erreichen positiv arbeitende Resists auf Methacrylatbasis eine hohe Auflösung, sind aber mit Ausnahme der Resists auf Polymethacrylnitril-Basis nicht gegen die zur Halbleiterstrukturierung verwendeten Plasmaätzprozesse stabil. Die Methacrylate wiederum sind aber nicht genügend empfindlich.

Die Polymeren mit der bisher höchsten bekannten Strahlungsempfindlichkeit für Elektronen- bzw. Röntgenstrahlen sind Polyalkensulfone, insbesondere das Polybuten-1-sulfon. Der Nachteil dieser Verbindungsklasse liegt aber in ihrer weniger guten Resistenz gegenüber Plasmaätzprozessen; sie sind daher zwar für die Maskenherstellung geeignet, nicht aber für die Halbleiterfertigung mit einer Maske aus diesem Material. Es wurde daher vorgeschlagen, Polyalkensulfone mit den bekanntermaßen plasmaätzresistenten Novolakharzen zu kombinieren (M.J. Bowden et al., J. Electrochem. Soc. 128, 1304 (1981); US-A-4 289 845). Es zeigte sich aber eine starke Unverträglichkeit der beiden Polymeren miteinander, wodurch die Auflösung beeinträchtigt wird. Auch der Versuch, die Verträglichkeit durch Beimischung weiterer Komponenten zu verbessern, mußte mit einem Verlust an Empfindlichkeit erkauft werden (US-A-4 398 001).

Photokatalytische Systeme werden für die Anwendung mit Elektronen- und Röntgenstrahlung in der DE-A-27 18 254 (= US-A 4 247 611) und DE-A-29 28 636 (= US-A 4 311 782) beschrieben. In diesen positiv arbeitenden Systemen werden als Verbindungen, die unter Einwirkung von aktinischer Strahlung eine Säure bilden, chlorhaltige Verbindungen, insbesondere des substituierten Triazintyps, eingesetzt. Bei der Strukturierung dieser Materialien mit Elektronen- oder Röntgenstrahlung zeigte sich aber, daß die Flanken der Resiststrukturen nach dem Entwickeln stark negativ unterhöhlt sind (Flankenwinkel um 60° nach einer Aufnahme mit einem Rasterelektronenmikroskop (REM)) und als Folge davon Strukturen unter ca. 2 µm nicht mehr aufgelöst bzw. abgebildet werden können oder aber zum Teil sehr stark ausgefranst sind.

In der DE-A-29 28 636 wird, wie auch in der DE-A 26 10 842 (= US-A 4 101 323) als chlorhaltige Verbindung u.a. 2,3,4,5-Tetrachloranilin genannt. Darüber hinaus werden in der DE-A-26 10 842 auch Verbindungen offenbart, die aliphatisch gebundenes Brom enthalten sowie eine, die Brom aromatisch gebunden trägt: 2,2',4,4',6,6'-Hexabromdiphenylamin.

Weitere chlor- und bromhaltige Verbindungen in lichtempfindlichen Materialien umfassen Hexabromdimethylsulfoxid in photographischen Schichten (DE-B 15 72 089 = GB-A 1 163 324), 2,2-Dibrom-2-(phenylsulfonyl)-acetophenon und verwandte Verbindungen als Polymerisationsstarter (DE-A 18 17 540 = US-A 3 615 455), trichlormethylsubstituierte Benzophenone als Polymerisationsstarter (DE-A-19 49 010 = US-A 3 686 084), Haloalkylbenzoxazole, -benzimidazole und -benzothiazole als Polymerisationsstarter (US-A 3 912 606) und seitenkettenhalogenierte Acetophenone als Photokatalysatoren säurehärtbarer Lacke (DE-A 23 17 846).

Eine Reihe dieser Verbindungen führen zu deutlichen Auflösungsverlusten. Durchweg treten unerwünschte Bildschleier auf, die eine praktische Anwendung derartiger Verbindungen als photolytische Säurespender in der Röntgenlithographie ausschließen. Insbesondere zeigen die aromatischen Chlorverbindungen eine unzureichende Auflösung; die genannten Verbindungen, die aromatisch gebundenes Brom enthalten, verursachen dagegen unerwünschte Bildschleier. Generell werden diese Bildschleier aber zurückgeführt auf eine zu geringe Löslichkeit der Starterverbindungen im wäßrigalkalischen Entwickler.

Es wurde daher vorgeschlagen, entsprechend der älteren deutschen Patentanmeldung P 38 21 585.3 als Starterverbindungen Verbindungen mit aromatisch gebundenem Chlor oder Brom einzusetzen, die einen pKa-Wert von unterhalb 12 aufweisen. Die genannten Verbindungen zeigen zwar gute Empfindlichkeiten bei Bestrahlung mit Synchrotronstrahlung, die mit ihnen erzielbaren Empfindlichkeiten bei Bestrahlung mit UV-Strahlung sind allerdings relativ gering.

Es bestand daher die Aufgabe, ein positiv arbeitendes strahlungsempfindliches Gemisch bereitzustellen, das eine hohe Empfindlichkeit gegenüber energiereicher Strahlung wie Elektronen- oder Röntgenstrahlung, insbesondere aber auch kurzwelliger UV-Strahlung und eine gute Auflösung aufweist, keine Bildschleier nach dem Entwickeln mit einem wäßrig alkalischen Entwickler zeigt und eine hinreichende Resistenz gegenüber dem Plasmaätzen besitzt.

Gelöst wird die Aufgabe durch Bereitstellen eines positiv arbeitenden strahlungsempfindlichen Gemisches, enthaltend eine Verbindung, die unter Einwirkung von kurzwelliger UV-Strahlung, von Röngten oder Elektronenstrahlung eine Säure bildet, sowie eine Verbindung, die durch Säure spaltbar ist, dadurch gekennzeichnet, daß die Verbindung, die eine Säure bildet, aliphatisch gebundenes Chlor oder Brom enthält, mindestens eine der Gruppen aufweist: eine phenolische OH-Gruppe, eine aliphatische OR-Gruppe mit stark elektronenziehenden Substituenten in der Nachbarschaft, eine aromatische SH-Gruppe, eine aliphatische oder eine aromatische Sulfonamiägruppe, eine aliphatische oder aromatische Imid-Gruppe, eine N-Acyl-substituierte Carbamatgruppe oder N-Acyl-substituierte Carbamidgruppe oder eine CH-acide Gruppierung und einen pKₐ-Wert von kleiner als 12 aufweist oder ein säurespaltbares Derivat einer solchen Verbindung mit einem derartigen pKₐ-wert ist.

Es war völlig überraschend, daß Verbindungen bzw. Starter, die aliphatisch gebundenes Chlor oder Brom enthalten und einen pKₐ-Wert von kleiner als 12 aufweisen, bzw. deren Derivate diese vorteilhaften Eigenschaften besitzen, nachdem die im Stand der Technik (DE-A-26 10 842) geoffenbarten, aliphatisch gebundenes Halogen, insbesondere Brom enthaltenden Verbindungen, sich als wenig geeignet erwiesen hatten.

Von den säurebildenden Startern bzw. den säurespaltbaren Derivaten dieser Verbindungen, die aliphatisch gebundenes Chlor oder Brom enthalten, werden solche bevorzugt, die einen pKₐ-Wert im Bereich von 6 bis 10 aufweisen bzw. Derivate dieser Verbindungen.

Der pKₐ-Wert von chemischen Verbindungen läßt sich nach herkömmlichen Methoden bestimmen, es ist aber auch eine theoretische Berechnung mit dem Programm "CAMEO" u.ä. möglich.

In der Regel bestehen die Starterverbindungen aus einer aliphatisch gebundenes Chlor oder Brom enthaltenden Gruppierung und einer funktionalen Gruppierung, die den erforderlichen pKₐ-Wert bestimmt.

Als funktionelle Gruppierungen, die einen derartigen pKₐ-Wert beitragen, kommen insbesonders in Frage: phenolische OH-Gruppen, aliphatische OH-Gruppen mit stark elektronenziehenden Substituenten in der Nachbarschaft, aromatische SH-Gruppen, aliphatische oder aromatische Sulfonamidgruppen, aliphatische oder aromatische Imid-Gruppen, N-acylsubstituierte Carbamatgruppen oder Carbamidgruppen, Nitrosubstituierte Alkylgruppen oder andere CH-acide funktionelle Gruppen, z.B. solche mit Carbonyl-, Cyano- oder Carbonsäureestergruppen in der Nachbarschaft. Pro Verbindung ist mindestens eine dieser Gruppen enthalten.

Als Substituenten für die N-acylsubstituierten Carbamat- oder Carbamidgruppen kommen Alkyl- oder Arylgruppen in Frage, insbesondere mit 2 bis 6 C-Atomen. Besonders bevorzugt sind (C₂-C₃)Alkylgruppen und Phenylgruppen, die jeweils auch wiederum substituiert sein können, insbesondere durch Hydroxyl. In diesen Fällen ist die Hydroxylgruppe als Substituent eines Alkylrestes insbesondere in ω-Positition, als Substituent eines Phenylrestes insbesondere in 4-Position lokalisiert.

Eine besondere Variante ist, daß die ggf. mit OH substituierten Arylgruppen als Substituenten eines N-acylsubstituierten Carbamats auftreten, während die ggf. mit OH substituierten Alkylgruppen als Substituenten insbesondere eines N-acylsubstituierten Carbamids auftreten.

Als CH-acide funktionelle Gruppe werden insbesondere β-Diketon- oder β-Ketoestergruppierungen genannt. Bei den Estern werden Alkylester, insbesondere die Methyl- oder Ethylester, bevorzugt. Die β-Diketoneinheiten können in einer α-Stellung zu den Carbonylgruppierungen insbesondere durch Phenyl oder Methyl substituiert sein.

Von den genannten funktionellen Gruppierungen, die den erforderlichen pKₐ-Wert bestimmen, ist pro Startermolekül insbesondere eine enthalten. Sofern es sich aber um N-acyl-substituierte Carbamate handelt, kann zusätzlich auch eine Hydroxyphenylgruppe im Molekül enthalten sein, insbesondere als Substituent des Stickstoffatoms.

Bevorzugte funktionelle Gruppierungen, die den geforderten pKₐ-Wert einstellen können, sind phenolische OH-Gruppen, Imidgruppen, N-acyl-substituierte Carbamat- oder Carbamidgruppen oder CH-acide funktionelle Gruppen.

Insbesondere bevorzugt werden Imidgruppen, N-acyl-substituierte Carbamat- oder Carbamidgruppen oder CH-acide funktionelle Gruppen. In einer besonderen Ausführungsform kann die die Alkalilöslichkeit bedingende Gruppierung auch säurelabil geschützt sein. Als Beispiel sei die Acetalisierung der phenolischen OH-Funktion durch Addition eines Vinylethers genannt. In diesen Fällen erfolgt die Entschützung in der Folge des Belichtungsschrittes und die derartig modifizierte Verbindung wird alkalilöslich.

Generell können aber Schutzgruppen jeder Art verwendet werden, die eine Veresterung von Hydroxylgruppen hervorrufen. Solche Schutzgruppen werden von Theodora W. Greene, Protective Groups in Organic Synthesis, John Wiley & Sons, 1981, beschrieben (87/K 754).

Die halogenhaltige funktionelle Gruppe kann das geforderte Brom oder Chlor in jeder aliphatisch gebundenen Form enthalten. Das Halogen kann dabei an ein sp³-, sp²- oder sp-hybridisiertes C-Atom gebunden sein. Bevorzugt ist ein an ein Sp³-hybridisiertes C-Atom gebundenes Halogen.

Bevorzugt sind aufgrund ihrer thermischen Stabilität Verbindungen, bei denen Halogenwasserstoff-Eliminierung wegen der Molekülstruktur nicht oder nur schwer möglich ist. Genannt seien Verbindungen, die in α-Stellung zum Halogensubstituenten keine Wasserstoffatome aufweisen, wie z.B. Trichlormethylcarbonyl- oder 2,2,2-Trichlor-1,1-difluorethyl-oder 2,2,2-Trichlor-tert.butylsubstituierte oder entsprechend niedriger halogenierte funktionelle Gruppen.

Bevorzugt sind die Trihalogenmethylcarbonyl-, die Trihalogenmethyl-, die Monohalogenmethylcarbonyl, die Monohalogenmethyl- und die 2,2,2-Trihalogen-tert. Butylgruppen. Insbesondere sind bevorzugt die Trichlormethylcarbonylgruppen, die Monobrommethylcarbonylgruppen und die Trichlormethylgruppen.

Bei Vorlage einer CH-aciden Verbindung kann das Halogen auch an dem C-Atom, an dem sich das acide H-Atom befindet, gebunden sein. Insbesondere trifft das für das Halogen Chlor und bei einem β-Ketoester zu. Ebenso kann das Halogen insbesondere als Trihalogenmethyl- und als Monohalogenmethylgruppe an die Carbonylgruppe im β-Diketon bzw. β-Ketoester gebunden sein.

Alternativ kommen auch funktionelle Gruppierungen in Frage, bei denen die Halogenwasserstoff-Eliminierung aufgrund der sterischen Anordnung nicht möglich ist, z.B. im Gammexyl (all-trans-Hexachlorcyclohexyl), d.h., daß am α-ständigen C-Atom keine Wasserstoffatome in trans-Stellung zum Halogenatom vorhanden sind.

In Ergänzung zu diesen aliphatisch gebundenen Halogenatomen können zusätzlich auch aromatisch gebundene Halogenatome im Molekül enthalten sein. Als besonders geeignet haben sich Molekülstrukturen herausgestellt, die in o,o-Position zu einer phenolischen OH-Gruppe zusätzlich chloriert oder bromiert sind.

In den im erfindungsgemäßen strahlungsempfindichen Gemisch enthaltenen Starter sind die halogenhaltigen funktionellen Gruppen mit den funktionellen Gruppen, die den pKₐ-Wert der Verbindung bestimmen, vorzugsweise durch eine Einfachbindung verknüpft.

Dies gilt allerdings nicht für polymere Starterverbindungen, insbesondere Homo- oder Copolymere mit Vinylphenoleinheiten.

Im Falle der Copolymeren ist das Halogen, insbesondere Chlor, über das Comonomere gebunden. Zu nennen sind bevorzugt Vinylchloride, Vinylbromide, Allylhalogenide, halogenhaltige Vinylester sowie halogenhaltige Ester der Acryl- oder Methacrylsäure.

Im Falle der Homopolymeren bilden insbesondere einzelne Hydroxygruppen der Hydroxyphenoleinheiten mit Trihalogenmethylcarbonylgruppen Ester. Bevorzugt ist jede 2. bis 5. Hydroxyphenoleinheit im Polymeren in dieser Weise umgesetzt.

Sowohl bei den Homo- wie bei den Copolymeren können zusätzlich oder anstelle der bisher genannten in o,o-Position zur Phenolgruppe Chlor oder Brom enthalten sein. Diese Ausführungsform ist aber nicht bevorzugt.

Die genannten Polymere enthalten im Durchschnitt insbesondere pro Einheit jeweils eine halogenhaltige Gruppe und eine Gruppe, die den pKₐ-Wert einzustellen vermag. Die Verbindungen haben ein Molekulargewicht im Bereich von 2.000 bis 100.000.

Die im erfindungsgemäßen strahlungsempfindlichen Gemisch enthaltenen Starter können allein oder in Kombination mit anderen Startern der genannten Klasse verwendet werden. Es sind aber auch Kombinationen mit anderen Startern möglich.

Zu diesen zählen Diazonium-, Phosphonium-, Sulfonium- und Iodonium-Salze, Halogenverbindungen, o-Chinondiazidsulfochloride und -ester sowie Organometall-Organohalogen-Kombinationen (vgl. DE-A-36 01 264).

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind.

Ebenso können auch Oxazole, Oxadiazole, Thiazol oder 2-Pyrone, die Trichlor- oder Tribrommethylgruppen enthalten, in Mischung mit den genannten Startern eingesetzt werden (DE-A-30 21 599, 30 21 590, 28 51 472, 29 49 396 sowie EP-A-0 135 348 und 0 135 863).

Daneben zählen zu den potentiellen Co-Starter-Verbindungen auch aromatische Verbindungen, die kernständiges Halogen, vorzugsweise Brom, aufweisen. Solche Verbindungen sind aus der DE-A-26 10 842 und den älteren deutschen Patentanmeldungen P 37 30 784.3 und 38 21 585.3 bekannt.

Als Vertreter einer Kombination mit einem Thiazol sei eine mit 2-Benzoylmethylen-naphtho [1,2-α]thiazol genannt (DE-A-28 51 641 und DE-A-29 34 758).

Ebenso stehen α-Halogencarbonsäureamide (DE-A-27 18 200) oder Tribrommethyl-phenylsulfone (DE-A-35 03 113), die z.B. durch Benzophenon, Benzil oder Michlers Keton sensibilisierat werden können, als Co-Starter in einer Starterkombination zur Verfügung.

Die genannten Co-Starter können mit den Startern, die aliphatisch gebundenes Halogen enthalten, in jedem Mengenverhältnis in dem erfindungsgemäßen strahlungsempfindlichen Gemisch vorliegen, jedoch mit der Maßgabe, daß die Starterkombination als Mischung einen pKₐ-Wert unterhalb von 12, insbesondere von 6 bis 10, aufweist.

Der Gehalt an Starterverbindungen insgesamt in dem erfindungsgemäßen strahlungsempfindlichen Gemisch liegt im allgemeinen bei 0,5 bis 50 Gew.-%, bevorzugt bei 2 bis 25 Gew-%, jeweils bezogen auf das Gesamtgewicht der Schicht.

Liegt der Starter in polymerer Form, insbesondere als Teil des Bindemittels vor, so gelten als Obergrenze die Gehalte, die unter den entsprechenden polymeren Bindemitteln angegeben sind. Aus den Mischungsverhältnissen der monomeren Ausgangsbestandteile läßt sich der jeweilige Gehalt des Starters bzw. der für den Start verantwortlichen Molekülgruppen im Polymeren berechnen.

Als säurespaltbares Material in dem erfindungsgemäßen strahlungsempfindlichen Gemisch haben sich vor allem folgende Verbindungsklassen bewährt:
a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
b) Oligomer- oder Polymerverbindungen mit wiederkehrenden Acetal- und/oder Ketalgruppierungen in der Hauptkette,
c) Verbindungen mit mindestens einer Enolether-, oder N-Acyliminocarbonatgruppierung,
d) cyclische Acetale oder Ketale von β-Ketoestern oder -amiden,
e) Verbindungen mit Silylethergruppierungen,
f) Verbindungen mit Silyl-enolethergruppierungen,
g) Monoacetale bzw. Monoketale, deren Aldehyd- bzw. Ketonkomponente eine Löslichkeit im Entwickler zwischen 0,1 und 100 g/l aufweisen,
h) Ether auf Basis tertiärer Alkohole und
i) Carbonsäureester und Carbonate tertiärer, allylischer oder benzylischer Alkohole

Durch Säure spaltbare Verbindungen des Typs a) als Komponenten strahlungsempfindlicher Gemische sind in der EP-A-0 022 571 und der DE-A-26 10 842 ausführlich beschrieben; Gemische, die Verbindungen des Typs b) enthalten, sind in der DE-C-23 06 248 und der DE-C-27 18 254 dargestellt; Verbindungen des Typs c) werden in den EP-A-0 006 626 und 0 006 627 beschrieben; Verbindungen des Typs d) werden in der EP-A 0 202 196 und Verbindungen, die dem Typ e) zuzurechnen sind, in den DE-A-3 544 165 und DE-A-3 601 264 vorgestellt; Verbindungen des Typs f) findet man in der gleichzeitig eingereichten Patentanmeldung P 37 30 783.5, während Verbindungen vom Typ g) in den ebenfalls gleichzeitig eingereichten Patentanmeldungen P 37 30 785.1 und P 37 30 787.8 behandelt werden. Verbindungen vom Typ h) werden z. B. in der US-A-4 603 101 beschrieben, Verbindungen vom Typ i) z. B. in der US-A-4 491 628 und von J. M. Frechet et al., J. Imaging Sci. 30, 59-64 (1986).

Es können auch Mischungen der genannten säurespaltbaren Materialien eingesetzt werden. Bevorzugt ist allerdings ein säurespaltbares Material, welches einem der oben genannten Typen zuzuordnen ist. Besonders bevorzugt sind von den Materialien diejenigen, die den Typen a), b), g) und i) angehören, insbesondere solche mit durch Säure spaltbaren C-O-C-Gruppierungen. Unter Typ b) sind insbesondere die polymeren Acetale hervorzuheben; von den säurespaltbaren Materialien des Typs g) insbesondere diejenigen, deren Aldehyd- bzw. Ketonkomponente einen Siedepunkt von größer als 150° C, vorzugsweise größer als 200° C, aufweist.

Der Gehalt an säurespaltbarem Material in dem erfindungsgemäßen strahlungsempfindlichen Gemisch sollte bei 1 bis 50 Gew.-%, vorzugsweise bei 5 bis 25 Gew.-%, jeweils bezogen auf das Gesamtgewicht der Schicht, liegen.

Das erfindungsgemäße strahlungsempfindliche Gemisch enthält ferner ein in Wasser unlösliches, in organischem Lösemittel und wäßrigem Alkali aber lösliches, zumindest quellbares Bindemittel. Hierunter zählen vor allem Phenolharze vom Novolak-Typ. Genannt werden Phenol-Formaldehyd-Harze, Kresol-Formaldehyd-Harze, deren Mischkondensate und deren Mischungen.

Daneben können auch noch Vinylpolymerisate wie Polyvinylacetale, Polymethacrylate, Polyacrylate, Polyvinylether, Polyvinylpyrrolidone sowie Styrolpolymerisate, jeweils ggf. durch Comonomere modifiziert, selbst oder in Mischung mit anderen, eingesetzt werden.

Im besonderen sind zu nennen: Polymere von Styrol mit Einheiten von Alkenylsulfonyl-aminocarbonyloxy- oder Cycloalkenylsulfonylaminocarbonyloxy- (EP-A-0 184 804), Polymere der Acryl-, Methacryl-, Malein-, Itaconsäure etc. mit seitenständigen, vernetzenden -CH₂OR-Gruppen (EP-A-0 184 044), Polymerisate aus Vinylmonomeren mit Alkenylphenoleinheiten (EP-A-0 153 682), Polyvinylphenole als Novolakersatz (DE-C-23 22 230), polymere Bindemittel mit seitenständigen, phenolischen Hydroxylgruppen (EP-A-0 212 439 und 0 212 440), Styrol-Maleinsäureanhydrid-Mischpolymerisate (DE-A-31 30 987), Polymere aus ungesättigten (Thio)phosphinsäureiso(thio)-cyanaten mit einem aktiven Wasserstoff enthaltenden Polymeren (DE-A-36 15 612 und 36 15 613), Polymere mit Vinylacetat-, Vinylalkohol- und Vinylacetaleinheiten (EP-A-0 216 083), Polyvinylacetale mit Einheiten aus Hydroxyaldehyden (DE-A-36 44 162) sowie Copolymere aus Maleinsäureimid und Styrol oder 3,5-disubstituierte Poly-4-hydroxystyrole.

Die Menge des Bindemittels beträgt im allgemeinen 1 bis 90, insbesondere 5 bis 90 Gew.-%, vorzugsweise 50 bis 90 Gew.-%, bezogen auf das Gesamtgewicht der strahlungsempfindlichen Mischung.

Auf die genannten, in Wasser unlöslichen, in Alkali aber löslichen Bindemittel kann ggf. verzichtet werden, wenn polymere alkalilösliche Starter verwendet werden. Insbesondere kommen hierfür die oben beschriebenen bromierten oder chlorierten Polystyrole oder Polyvinylphenole in Frage. Dies hat zur Folge, daß der Gehalt des polymeren Starters auch über den für den Starter beschriebenen Bereich hinausgehen kann. Insbesondere werden Gehalte von größer als 50 Gew.-% und bis zu 100 Gew.-%, abzüglich des Gehalts der Verbindung, die durch Säure spaltbar ist, in Anspruch genommen.

Daneben ist es auch möglich, das Bindemittel durch Kondensation einer im erfindungsgemäßen Gemisch als Co-Starter enthaltenen chlor- oder bromhaltigen aromatischen Starter mit einem Ausgangsmonomeren, das für die Darstellung herkömmlicher Bindemittel bekannt ist, herzustellen. Voraussetzung ist, daß das säurebildende chlor- oder bromhaltige Material zur Kondensation oder Polymerisation fähige Gruppen aufweist.

Von seiten der monomeren Bestandteile herkömmlicher Bindemittel werden für diese Kondensation in erster Linie Phenole und Kresole, insbesondere m-Kresol bevorzugt. Die Kondensation erfolgt vorzugsweise mit etwa äquimolaren Mengen.

Neben dieser "Einkondensation" des chlor- oder bromhaltigen Starters mit monomeren Bestandteilen bekannter Bindemittel zu einem polymeren Starter, der gleichzeitig als Bindemittel wirkt, ist auch ein einfaches Mischen, in diesem Fall aber von einem polymeren Starter und herkömmlichen Bindemitteln möglich. Insbesondere werden bromhaltige Styrolderivate mit Novolakharzen gemischt, vorzugsweise in etwa äquimolaren Anteilen.

Ferner können den erfindungsgemäßen strahlungsempfindlichen Gemischen ggf. Farbstoffe, Pigmente, Weichmacher, Netzmittel und Verlaufmittel, aber auch Polyglykole, Celluloseether, z.B. Ethylcellulose, zur Verbesserung spezieller Erfordernisse wie Flexibilität, Haftung und Glanz zugesetzt werden.

Vorzugsweise wird das erfindungsgemäße strahlungsempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatische Estern wie Ethylacetat, Hydroxyethylacetat, Alkoxyethylacetat, n-Butylacetat, Propylenglykolmonoalkyletheracetat, insbesondere Propylenglykolmethyletheracetat oder Amylacetat; Ethern wie Dioxan, Ketonen wie Methylethylketon, Methyl-isobutylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran, und in Mischungen derselben gelöst. Besonders bevorzugt werden Glykolether, aliphatische Ester sowie Ketone.

Die mit den Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen bestehend aus einem Substrat und dem darauf aufgetragenen strahlungsempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus thermisch oxidiertem und/oder mit Aluminium beschichtetem Siliciummaterial zu nennen, die gegebenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, ggf. mit Aluminium beschichtete SiO₂-Materialien und Papier. Diese Substrate können einer Temperatur-Vorbehandlung unterzogen werden, oberflächlich angerauht, angeätzt oder zur Verbesserung erwünschter Eigenschaften, z. B. der Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Substrat einen Haftvermittler enthalten. Bei Silicium- bzw. Siliciumdioxid-Substraten kommen hierfür Haftvermittler vom Aminosilan-Typ, wie z.B. 3-Aminopropyl-triethoxysilan oder Hexamethyl-disilazan in Frage.

Beispiele für Träger, die zur Herstellung von photomechanischen Aufzeichnungsschichten wie Druckformen für den Hochdruck, den Flachdruck, den Siebdruck, den Tiefdruck sowie von Reliefkopien Verwendung finden können, sind Aluminiumplatten, ggf. anodisch oxidiert, gekörnte und/oder silikatisierte Aluminiumplatten, Zinkplatten, Stahlplatten, die ggf. verchromt wurden, sowie Kunststoffolien oder Papier.

Bestrahlt wird das erfindungsgemäße Aufzeichnungsmaterial bildmäßig mit hochenergetischen Strahlungsquellen; bevorzugt ist Elektronen- oder Röntgenstrahlung.

Die Schichtstärke variiert in Abhängigkeit von ihrem Einsatzgebiet. Sie beträgt zwischen 0,1 und 100 µm, insbesondere zwischen 1 und 10 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuderbeschichten und Tauchbeschichten erfolgen. Danach wird das Lösungsmittel durch Verdampfen entfernt, so daß auf der Oberfläche des Substrates die strahlungsempfindliche Schicht zurückbleibt. Die Entfernung des Lösemittels kann gegebenfalls durch Erhitzen der Schicht auf Temperaturen von bis zu 150° C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien ausgewiesene Materialien Anwendung finden. Anschließend wird die Schicht bildmäßig bestrahlt. Bevorzugt sind energiereiche Strahlungen wie Röntgen- oder Elektronenstrahlung, z.B. eine Synchrotronstrahlung mit Dosiswerten von 20 bis 200 mJ/cm² oder Strahlung eines Elektronenstrahlschreibers. Insbesondere bevorzugt ist die Bestrahlung mit kurzwelligem UV-Licht. In der strahlungsempfindlichen Schicht wird anschließend durch Entwicklung ein Bildmuster freigelegt, indem die Schicht mit einer Entwicklerlösung behandelt wird, die die bestrahlten Bereiche des Materials löst bzw. entfernt.

Als Entwickler werden Lösungen von alkalischen Reagenzien wie z.B. Silikaten, Metasilikaten, Hydroxiden, Hydrogen- bzw. Dihydrogenphosphaten, Carbonaten bzw. Hydrogencarbonaten, insbesondere von Alkali- oder Ammoniumionen, aber auch Ammoniak und organische Ammoniumbasen und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Zur Erhöhung der Resistenz gegen mechanische und chemische Einflüsse, insbesondere gegen Ätzmedien, können die entwickelten Schichten noch einige Zeit, z.B. 5 bis 40 Minuten, auf erhöhte Temperatur, z.B. oberhalb 100° C, erhitzt werden, wobei diese Wirkung noch durch Belichten mit UV-Strahlung unterstützt werden kann.

Anhand der folgenden Beispiele soll die Herstellung der im erfindungsgemäßen strahlungsempfindlichen Gemisch enthaltenen und zum Teil neuen, aromatisches Chlor oder Brom enthaltenden Verbindungen verdeutlicht werden:

### Herstellungsbeispiel 1

### O-2,2,2-Trichlorethyl-N-(4-hydroxyphenyl)-carbamat

4,3 g (0,02 mol) Chlorameisensäure-2,2,2-trichlorethylester werden in 20 ml DMF gelöst und zu einer Lösung aus 10,9 g (0,1 mol) 4-Hydroxyanilin in 100 ml DMF getropft. Nach einer Stunde Nachrühren bei Raumtemperatur wird das Gemisch in Eiswasser gegossen, angesäuert, abgesaugt und mit Wasser nachgewaschen. Das Produkt wird aus Toluol mit Aktivkohle umkristallisiert.

Man erhält 2,3 g einer Substanz vom Schmelzpunkt 134° C; ¹H-NMR: -NH- 9.17 ppm (s, 1H), -CH₂- 4,9 ppm (s, 2H), -OH (+H₂O) 3,31 ppm (s), Aromaten 6,67 ppm (d, 2H) 7,27 ppm (d, 2H).

### Herstellungsbeispiel 2

### N-Trichloracetyl-N'-3-hydroxypropyl-harnstoff

3,75 g 3-Aminopropanol werden in einem Gemisch aus 10 g Wasser und 10 g Aceton gelöst. Anschließend werden 9,4 g Trichloracetylisocyanat zugetropft. Nach leicht exothermer Reaktion wird eine Stunde bei Raumtemperatur gerührt, dann 2,5 h unter Rückfluß gehalten. Nach dem Einengen am Rotationsverdampfer erhält man 7,7 g einer öligen Phase, die in Aceton aufgenommen wird und einer Säulenchromatographie an Silicagel mit Cyclohexan-Ethylacetat (1:1) als Laufmittel unterzogen wird.

Man erhält 4,3 g eines Öls; ¹H-NMR: -NH- 7,7 ppm (breit), -CH₂- 3,80 (t, 2H), 3,52 (q, 2H), 1,84 ppm (p, 2H), -OH 2,64 ppm (s, 1H).

### Herstellungsbeispiel 3

### N-Trichloracetyl-O-phenyl-carbamat

4,7 g (0,05 mol) Phenol werden in einem Gemisch aus 10 g Wasser und 10 g Aceton gelöst. Anschließend werden innerhalb 30 min 9,4 g (0,05 mol) Trichloracetylisocyanat zugetropft. Es wird 30 min bei Raumtemperatur und 2,5 h unter Rückfluß nachgerührt. Das Lösungsmittelgemisch wird am Rotationsverdampfer eingeengt und der erhaltene Feststoff aus DMSO umkristallisiert.

Man erhält 6,1 g einer Substanz vom Schmelzpunkt 148° C; ¹H-NMR: Signale bei ca. 8 ppm.

### Herstellungsbeispiel 4

### 4-Brom-3-oxo-buttersäure-ethylester

32,5 g (0,25 mol) Acetessigester werden in 64 ml Eisessig gelöst. Zu der gekühlten Lösung werden 40 g (0,25 mol) Brom zugetropft. Das Gemisch bleibt über Nacht stehen und wird dann in kaltes Wasser gegossen. Das erhaltene Öl wird mit Wasser gewaschen, getrocknet und im Wasserstrahlvakuum destilliert.

Die Feindestillation erfolgte bei 0,08 Torr, der Siedepunkt beträgt dort 53° C. ¹H-NMR: -CH₃ 1,28 ppm (t, 3H), -CH₂- 4,20 ppm (Ester, q, 2H), sowie Signale bei 12,0 ppm, 3,70 ppm, 4,05 ppm, 4,16 ppm.

### Herstellungsbeispiel 5

### 2-Chlor-3-oxo-Buttersäure-ethylester

32,5 g (0,25 mol) Acetessigester werden in 64 ml Methylenchlorid gelöst. Zu dieser Lösung werden 33,74 g (0,25 mol) Sulfurylchlorid zugetropft und das Gemisch dann - nach Beendigung der Gasentwicklung - eine Stunde zum leichten Sieden erhitzt. Nach dem Abdestillieren des Methylenchlorids wird bei 86 - 92° C/12 Torr destilliert. Man erhält 38,8 g Substanz, ¹H-NMR: -CH₃ 1,31 ppm (t, 3H), -CH₂- (Ester) 4,28 ppm (q, 2H), -CH₃ (Acetyl) 2,38 ppm (s, 3H), -CHCl- 4,76 ppm (s, 1H).

### Herstellungsbeispiel 6

### 4-Trichloracetyl-phenol

13,86 g AlCl₃ und 10,7 ml Chlorbenzol werden bei 5° C vorgelegt. Eine Lösung von 5,06 g Phenol in 5,4 ml Chlorbenzol wird bei 5° C zugetropft, anschließend wird ebenfalls bei dieser Temperatur 8 ml Trichloracetonitril zugetropft. Unter Einleiten von HCl wird auf 60° C erwärmt und so lange weitergerührt, bis eine klare Lösung entstanden ist. Danach werden weitere 65 h bei 60° C gerührt, das Produkt auf Eis gegossen, mit Ether extrahiert, die etherische Phase gewaschen, mit Natriumsulfat getrocknet und eingeengt.

Die Vakuumdestillation bei 0,1 mm ergibt einen Siedepunkt von 140° C; ¹H-NMR: -OH 6.2 ppm (breit, s), Aromaten: 6,95 ppm (d, 2H) und 8,24 ppm (d, 2H).

### Herstellungsbeispiel 7

### 1,1,1-Trichlor-acetylaceton

a) Vorstufe: 1,1,1-Trichlor-2-amino-penten-2-on-4 (nach M. Coenen et al, J. Prakt. Chem. (4) 27, 239 (1965))
   50 g (0,5 mol) Acetylaceton und 70 g (0,5 mol) Trichloracetonitril werden in 200 ml Methanol gelöst. Man läßt bei 20 - 30° C 100 ml gesättigte Natriumacetatlösung zutropfen. Dabei färbt sich das Reaktionsgemisch gelb, die Temperatur steigt auf 60° C an. Nach zweistündigem Rühren wird in 2 l Wasser gerührt, das ausgefallene ölige Produkt wird allmählich fest. Es wird abgesaugt, getrocknet und aus Hexan umkristallisiert.
   Man erhält 85 g einer Substanz vom Schmelzpunkt 67° C; ¹H-NMR: -CH₃ 2,19 ppm (s), -CH= 5,9 ppm (t, 1H), -NH₂ 7-8,5 ppm (breit, 2H).
b) 1,1,1-Trichloracetylaceton (nach C. Ringel, R. Mayer, J.prakt. Chem. (4), 26, 333 (1964))
   50 g 1,1,1-Trichlor-2-amino-penten-2-on-4 werden bei Raumtemperatur mit 100 ml konz. Salzsäure verrührt, wobei sich unter leichter Erwärmung Ammoniumchlorid und die Zielverbindung abscheiden. Nach zwei Stunden werden 80 ml Wasser zugegeben. Man trennt die ölige Schicht ab und nimmt sie in 150 ml Ether auf, trocknet über Natriumsulfat, engt am Rotationsverdampfer ein und destilliert den Rückstand bei 0,15 mm und 46° C.
   Man erhält 31 g eines Öls; ¹H-NMR: -CH₃ 2,19 ppm (s, 3H), -CH= 6,11 ppm (s, 1H), -OH 13,6 ppm (breit, 1H). Die Verbindung liegt zu etwa 94 % in der Enolform vor (in CDCl₃ bei Raumtemperatur), die Ketoform zeigt Signale bei: -CH₃ 2,34 ppm und -CH₂- 4,10 ppm (Verhältnis 3:2).

### Herstellungsbeispiel 8

### ω,ω,ω-Trichlor-benzoylaceton

a) Vorstufe:
   1,1,1-Trichlor-2-amino-4-phenyl-4-oxobuten-(2) (nach M. Coenen et al, J. Prakt. Chemie (4) 27, 248 (1965))
   Die Darstellung erfolgt analog zur Darstellung der Vorstufe aus Herstellungsbeispiel 7 mit dem Unterschied, daß anstelle des Acetylacetons Benzoylaceton verwendet wird.
   Man erhält ein Produkt mit einem Schmelzpunkt von 104° C. (Lit.: 102-103° C). ¹H-NMR: -CH= 6,63 ppm (t, 1H), Aromaten und -NH₂ 7 - 8,2 ppm (7H).
b) ω,ω,ω-Trichlor-benzoylaceton
   (nach C. Ringel, R. Mayer, J. prakt. Chem. (4), 26, 333 (1964))
   Es wird vorgegangen analog zu Herstellungsbeispiel 7 mit dem Unterschied, daß eine Benzoyl-substituierte anstelle der Acetyl-substituierten Verbindung eingesetzt wird.
   Es wird ein Öl erhalten mit einem Siedepunkt von 112° C/0,2 mm (Lit.: 102° C/0,09 mmHg) ¹H-NMR: -CH= (Enolform) 6,80 ppm (s, 1H), -OH 14,25 ppm (s, 1H), Aromaten 7,3 - 8,0 ppm (5H). Die Ketoform liegt in CDCl₃ bei Raumtemperatur zu etwa 15 % vor und liefert ein -CH₂- 7,25 ppm (s).

### Herstellungsbeispiel 9

### 4,4,4-Trichloracetessigsäure-methylester

a) Vorstufe:
   3-Amino-4,4,4-trichlor-crotonsäure-methylester (nach M. Coenen et al, J. Prakt. Chem. (4) 27, 239 (1965))
   Es wird vorgegangen analog der Vorstufe zu Herstellungsbeispiel 8 mit dem Unterschied, daß anstelle von Acetylaceton Acetylessigsäure-methylester eingesetzt wird.
   Man erhält einen kristallinen Feststoff mit einem Schmelzpunkt von 54° C. (Lit.: 53-54° C), ¹H-NMR: -CH₃ 3,71 ppm (s, 3H), -CH= 5,51 ppm (t, 1H), -NH₂ 6-7 ppm (breit, 2H).
b) 4,4,4-Trichloracetessigsäure-methylester (nach C. Ringel, R. Mayer, J. Prakt. Chem. (4), 26, 333 (1964))
   Es wird vorgegangen wie in Herstellungsbeispiel 8, jedoch mit dem Unterschied, daß Aminocrotonsäureester anstelle Benzoyl-butenons eingesetzt wird.
   Man erhält eine Substanz mit einem Siedepunkt von 60° C/0,1 mm; ¹H-NMR: -CH₃ 3,80 ppm (s, 3H), -CH₂- 4,04 ppm (s, 2H). Das Produkt liegt in CDCl₃ bei Raumtemperatur zu etwa 15 % in der Enolform vor, die folgende NMR-Signale zeigt: -CH= 7,29 ppm (s), -OH 12,45 ppm (s).

Im folgenden werden die in den Herstellungsbeispielen beschriebenen aliphatisches Halogen enthaltenden Starterverbindungen in verschiedenen erfindungsgemäßen strahlungsempfindlichen Gemischen getestet. Die Erfindung gemäß der Beschreibung soll aber nicht auf diese Beispiele beschränkt sein.

In diesen Beispielen steht "Gt" für "Gewichtsteile" und Prozentangaben sind, wenn nichts anderes angegeben ist, als Gewichtsprozente zu deuten.

### Anwendungsbeispiel 1

Es wurde eine Beschichtungslösung hergestellt aus

| | |
|---|---|
| 17 Gt | eines Kresol-Formaldehyd-Novolaks mit einem Erweichungsbereich von 105-120° C, |
| 5 Gt | p-Hydroxybenzaldehyd-bis(phenoxyethyl)acetal, hergestellt analog dem Herstellungsbeispiel 1 von Benzaldehyddiphenoxyethylacetal aus der älteren deutschen Patentanmeldung P 37 30 787.8 und |
| 4 Gt | O-2,2,2-Trichlorethyl-N-(4-hydroxyphenyl)-carbamat (Herstellungsbeispiel 1) in |
| 74 Gt | Propylenglykolmonomethyletheracetat. |

Die Lösung wurde auf einen mit einem Haftvermittler (Hexamethyl-disilazan) behandelten Siliciumwafer bei 3.000 U/min aufgeschleudert. Nach der Trocknung bei 110° C für 1 min auf der Hot Plate wurde eine Schichtdicke von 1 µm erhalten. Bildmäßig bestrahlt wurde mit Synchrotron-Strahlung (BESSY, Berlin, 754 MeV) durch eine Gold-auf-Silicium-Maske mit einer Dosis von 85 mJ/cm². Den experimentellen Aufbau findet man bei A. Heuberger, "X-Ray Lithography", Microelectronic Engineering 3, 535-556 (1985). Nach dem Belichten wurde die Resistschicht 5 Minuten bei Raumtemperatur belassen. Entwickelt wurde mit einem 0,3 n alkalischen Entwickler folgender Zusammensetzung:
5,3 Gt Natriummetasilikat x 9 H₂O,
3,4 Gt Trinatriumphosphat x 12 H₂O,
0,3 Gt Natriumdihydrogenphosphat und
191 Gt vollentsalztes Wasser.

Nach einer Entwicklungsdauer von 50 s erhielt man ein fehlerfreies Bild mit allen Details der Maske. Die Resistflanken waren nicht negativ unterhöhlt, sondern zeigten einen Winkel von nahezu 90° (in einer Aufnahme eines Rasterelektronenmikroskops (REM)).

### Anwendungsbeispiele 2 bis 15

Analog zu Anwendungsbeispiel 1 wurden Beschichtungslösungen mit 25 Gew.-% Feststoffgehalt in Propylenglykolmethyletheracetat ®Dowanol PMA, Dow Chemical) hergestellt.

Die folgende Tabelle I zeigt das in diesen Anwendungsbeispielen verwendete Bindemittel (Novolak-Harz mit einer Glastemperatur von mindestens 110° C, gemäß der älteren deutschen Patentanmeldung P 38 10 632.9), die Starterverbindungen und die durch Säure spaltbaren Verbindungen, jeweils in ihren Gewichtsprozentanteilen, bezogen auf den 25 Gew.-%igen Feststoffgehalt der Beschichtungslösungen, sowie die Bestrahlungsdosis einer Synchrotron-Strahlung (BESSY, Berlin, 754 MeV, vgl. Anwendungsbeispiel 1), die verwendete Entwicklungslösung und die Entwicklungszeit, die notwendig war, um eine gute Strukturübertragung zu gewährleisten. In allen geschilderten Fällen konnten gute Strukturübertragungen mit senkrechten Flanken erzielt werden, ohne daß es zum Auftreten von Bildschleiern gekommen ist.

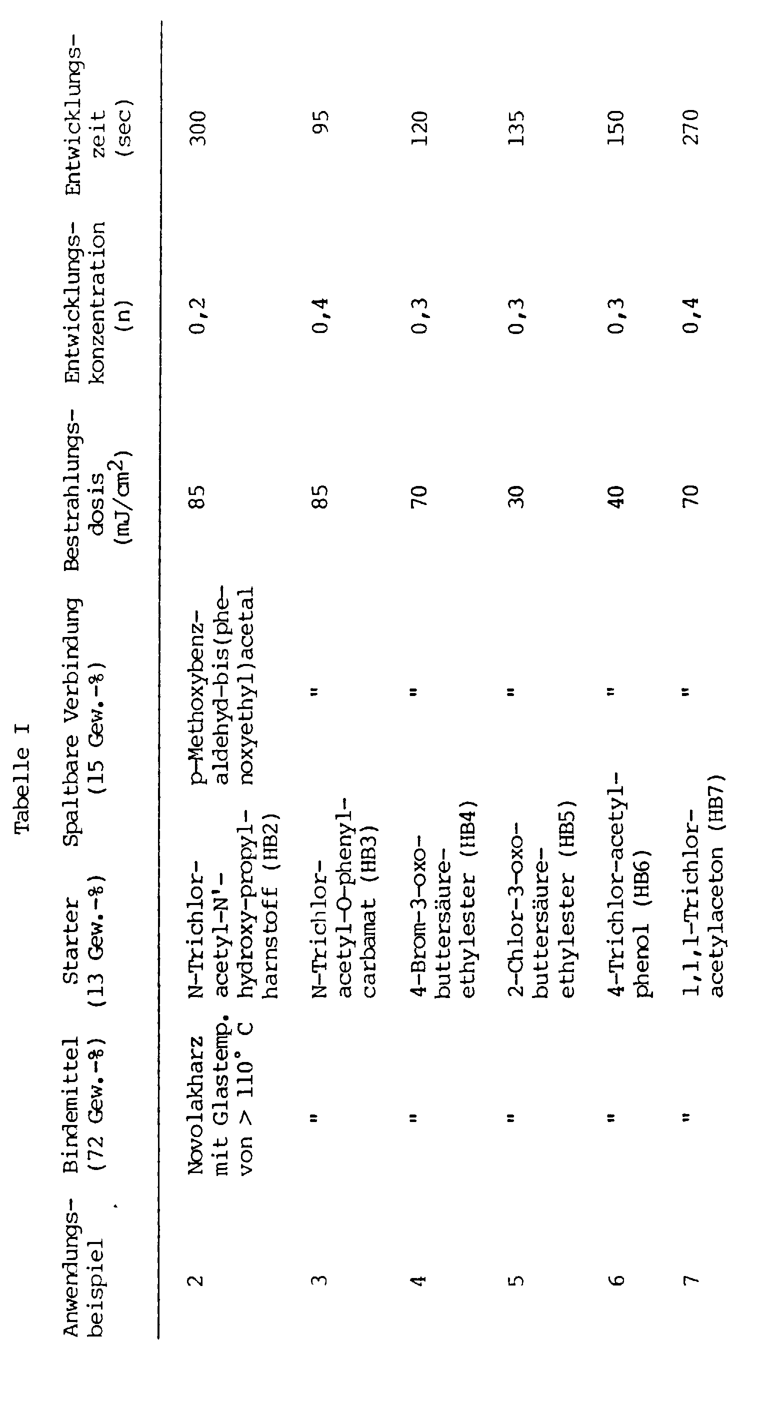

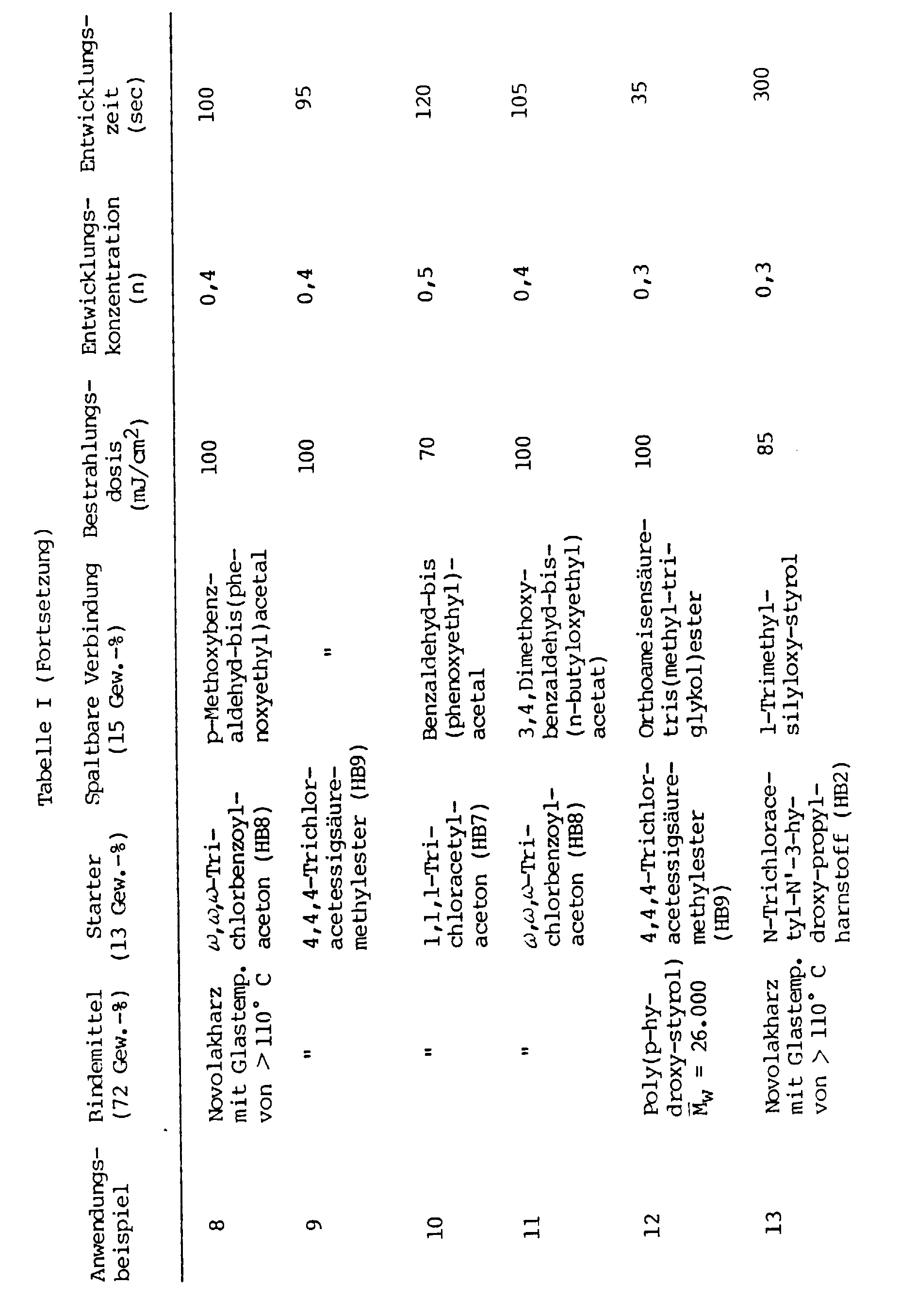

### Anwendungsbeispiele 14 und 15 (Vergleichsbeispiele)

Zum Vergleich wurden analog zu den Anwendungsbeispielen 2 bis 13 Beschichtungslösungen hergestellt, jedoch mit Starterverbindungen, die z.T. zwar aliphatisches Halogen enthalten, aber nicht den erfindungsgemäß verwendeten Starterverbindungen entsprachen, d.h. nicht über Gruppierungen im Molekül verfügen, die einen pKₐ-Wert von unterhalb von 12 einstellen können. Die Beschichtungslösungen sind aus Tabelle II zu erkennen. Auch hier bildeten die genannten Schichtbestandteile einen Feststoffgehalt von 25 Gew.-%, die Beschichtungslösung wurde durch Zugabe von 75 Gew.-% Propylenglykolmonomethyletheracetat hergestellt. Als Entwicklungslösung wurde der ®AZ developer aus den Anwendungsbeispielen 2 bis 13 verwendet, in den unten angegebenen Konzentrationen.

| Anwendungsbeispiel | Bindemittel (72 Gew.-%) | Starter (13 Gew.-%) | Spaltbare Verbindung (15 Gew.-%) | Bestrahlungsdosis (mJ/cm²) |
|---|---|---|---|---|
| 14 (V) | Novolak-Harz mit Glastemperatur von >110° C | Triphenylsulfoniumhexafluorophosphat (sulf) | p-Methoxybenzaldehyd-bis(phenoxyethyl)acetat | 100 |
| 15 (V) | " | 2,2-Bis-(4-chlorphenyl)-1,1,1-trichlorethan (DDT) | " | 100 |

In Anwendungsbeispiel 14 mußte trotz Verwendung eines konzentrierten Entwicklers einer Normalität von 0,6 n 360 sec entwickelt werden. In Anwendungsbeispiel 15 konnte zwar mit einem 0,45 n-Entwickler nach 270 sec eine Entwicklung erzielt werden, es wurde aber deutliches Scumming beobachtet, das sich erst durch ein Entwickeln mit einem 0,6 n-Entwickler nach 30 sec. entfernen ließ. Die feinen Linien werden durch die notwendige lange Entwicklungszeit unterschnitten und schließlich weggespült.

## Patentansprüche

1. Positiv arbeitendes strahlungsempfindliches Gemisch, enthaltend eine Verbindung, die unter Einwirkung von kurzwelliger UV-Strahlung, von Röntgen- oder Elektronenstrahlung eine Säure bildet, sowie eine Verbindung, die durch Säure spaltbar ist, dadurch gekennzeichnet, daß die Verbindung, die eine Säure bildet, aliphatisch gebundenes Chlor oder Brom enthält, mindestens eine der Gruppen aufweist: eine phenolische OH-Gruppe, eine aliphatische OH-Gruppe mit stark elektronenziehenden Substituenten in der Nachbarschaft, eine aromatische SH-Gruppe, eine aliphatische oder eine aromatische Sulfonamidgruppe, eine aliphatische oder aromatische Imid-Gruppe, eine N-Acyl-substituierte Carbamatgruppe oder N-Acyl-substituierte Carbamidgruppe oder eine CH-acide Gruppierung und einen pKₐ-Wert von kleiner als 12 aufweist oder ein durch Säurekatalyse in die freie Verbindung überführbares Derivat einer solchen Verbindung mit einem derartigen pKₐ-Wert ist.

2. Positiv arbeitendes Gemisch nach Anspruch 1, dadurch gekennzeichnet, daß die säurebildende Verbindung einen pKₐ-Wert von 6 bis 10 aufweist.

3. Positiv arbeitendes Gemisch nach Ans ruch 1, dadurch gekennzeichnet, daß das Chlor- oder Brom atom an ein sp³-hybridisiertes C-Atom gebunden ist.

4. Positiv arbeitendes 3 Gemisch nach einem oder mehreren der Ansprüche 1 bis 3, dadurch gekennzeichnet, daß die säurebildende Verbindung in α-Stellung zu dem Chlor- oder Bromsubstituenten tragenden C-Atom kein Wasserstoffatom aufweist.

5. Positiv arbeitendes Gemisch nach den Ansprüchen 3 und 4, dadurch gekennzeichnet, daß die säurebildende Verbindung eine chlorierte oder bromierte Acetylgruppierung aufweist.

6. Positiv arbeitendes Gemisch nach Anspruch 1, dadurch gekennzeichnet, daß die säurebildende Verbindung eine chlorierte oder bromierte tert.Butylgruppe aufweist.

7. Positiv arbeitendes Gemisch nach Anspruch 1, dadurch gekennzeichnet, daß die säurebildende Verbindung an dem zum halogen-substituierten C-Atom α-ständigen C-Atom keine Wasserstoffatome in trans-Stellung zum Chlor- oder Bromatom aufweist.

8. Positiv arbeitendes Gemisch nach Anspruch 1, dadurch gekennzeichnet, daß die säurebildende Verbindung zusätzlich zu aliphatisch gebundenen Chlor- oder Brom atomen auch aromatisch gebundene Halogenatome aufweist.

9. Positiv arbeitendes Gemisch nach Anspruch 8, dadurch gekennzeichnet, daß die aromatisch gebundenen Chlor- oder Brom atome in o-Position zu einer phenolischen OH-Gruppe stehen.

10. Positiv arbeitendes Gemisch nach Anspruch 1, dadurch gekennzeichnet, daß der aliphatisch gebundenes Brom oder Chlor enthaltende Substituent einfach oder mehrfach an ein alkalilösliches Polymeres gebunden ist.

11. Positiv arbeitendes Gemisch nach einem oder mehreren der Ansprüche 1 bis 10, dadurch gekennzeichnet, daß das Gemisch zusätzlich ein alkalilösliches Bindemittel enthält.

12. Positiv arbeitendes Aufzeichnungsmaterial, im wesentlichen bestehend aus einem Träger und einer strahlungsempfindlichen Schicht, dadurch gekennzeichnet, daß die Schicht auf einem strahlungshärtbaren Gemisch gemäß einem oder mehreren der Ansprüche 1 bis 11 besteht.

13. Verfahren zur Aufzeichnung von hochenergetischer Strahlung mittels des positiv arbeitenden Aufzeichnungsmaterials nach Anspruch 12, dadurch gekennzeichnet, daß ein strahlungshärtbares Gemisch gemäβ den Ansprüchen 1 bis 11 auf einen ggf. mit einem Haftvermittler beaufschlagten Träger aufgebracht wird, das Material getrocknet, anschließend mit energiereicher Strahlung, insbesondere Röntgen- oder Elektronenstrahlung oder kurzwelliger UV-Strahlung, bildmäßig bestrahlt, danach ggf. bei erhöhter Temperatur getempert und abschließend das Bild durch Entfernen der unbestrahlten Schichtbereiche mit einem wässrig-alkalischen Entwickler entwickelt wird.

## Claims

1. A positive radiation-sensitive mixture, containing a compound which forms an acid under the action of deep UV radiation, X-rays or electron beams, and an acid-cleavable compound, wherein the compound which forms an acid contains aliphatically bound chlorine or bromine and at least one of the groups: a phenolic OH group, an aliphatic OH group having strongly electron-withdrawing substituents in the vicinity, an aromatic SH group, an aliphatic or an aromatic sulfonamide group, an aliphatic or an aromatic imide group, an N-acyl-substituted carbamate group or N-acyl-substituted carbamide group or a CH-acidic group, and has a pKₐ value of less than 12, or is a derivate of such a compound having such a pKₐ value which can be converted into the free compound by acid catalysis.

2. A positive mixture as claimed in claim 1, wherein the acid-forming compound has a pKₐ value of from 6 to 10.

3. A positive mixture as claimed in claim 1, wherein the chlorine or bromine atom is bound to an sp³-hybridized carbon atom.

4. A positive mixture as claimed in one or more of claims 1 to 3, wherein the acid-cleavable compound does not contain a hydrogen atom in the α-position relative to the carbon atom carrying chlorine or bromine substituents.

5. A positive mixture as claimed in claims 3 and 4, wherein the acid-forming compound contains a chlorinated or brominated acetyl group.

6. A positive mixture as claimed in claim 1, wherein the acid-forming compound contains a chlorinated or brominated tert-butyl group.

7. A positive mixture as claimed in claim 1, wherein the acid-forming compound, on the α-carbon atom relative to the halogen-substituted carbon atom, does not carry any hydrogen atoms in the trans-position relative to the chlorine or bromine.

8. A positive mixture as claimed in claim 1, wherein the acid-forming compound, in addition to aliphatically bound chlorine or bromine, also contains aromatically bound halogen atoms.

9. A positive mixture as claimed in claim 8, wherein the aromatically bound chlorine or bromine atoms are in the o-position relative to a phenolic OH group.

10. A positive mixture as claimed in claim 1, wherein the substituent containing aliphatically bound bromine or chlorine is bound in once or several times to an alkali-soluble polymer.

11. A positive mixture as claimed in one or more of claims 1 to 10, wherein the mixture additionally contains an alkali-soluble binder.

12. A positive recording material, essentially comprising a substrate and a radiation-sensitive coating, wherein the coating comprises a radiation-curable mixture as claimed in one or more of claims 1 to 11.

13. A process for recording high-energy radiation by means of the positive recording material as claimed in claim 12, which comprises applying a radiation-curable mixture as claimed in claims 1 to 11 to a substrate, which is optionally coated with an adhesion promoter, drying the material, and subsequently irradiating it imagewise with high-energy radiation, in particular X-ray or electron radiation or short-wave UV radiation, subsequently conditioning the material, if necessary, at elevated temperature, and finally developing the image by removing the non-irradiated areas of the coating using an aqueous-alkaline developer.

## Revendications

1. Composition sensible aux radiations, travaillant en positif, contenant un composé qui forme un acide sous l'effet d'un rayonnement UV à courte longueur d'onde, de rayons X ou d'un faisceau d'électrons, ainsi qu'un composé qui est dissociable par un acide, caractérisée en ce que le composé qui forme un acide contient du chlore ou du brome lié à un radical aliphatique, comporte au moins l'un des groupes suivants: un groupe OH phénolique, un groupe OH aliphatique ayant dans son voisinage des substituants attirant fortement les électrons, un groupe SH aromatique, un groupe sulfonamido aliphatique ou aromatique, un groupe imido aliphatique ou aromatique, un groupe carbamate substitué à l'azote par un radical acyle, ou un groupe carbamido substitué à l'azote par un radical acyle, ou un groupement CH-acide, et présente un pKₐ inférieur à 12, ou est un dérivé. dissociable par catalyse acide d'un tel composé ayant un tel pKa.

2. Composition travaillant en positif selon la revendication 1, caractérisée en ce que le composé générateur d'acide présente un pKₐ de 6 à 10.

3. Composition travaillant en positif selon la revendication 1, caractérisée en ce que le chlore ou le brome est lié à un atome de carbone hybridé en sp³.

4. Composition travaillant en positif selon une ou plusieurs des revendications 1 à 3, caractérisée en ce que le composé générateur d'acide ne présente pas d'atome d'hydrogène en position α par rapport à l'atome de carbone portant le substituant chlore ou brome.

5. Composition travaillant en positif selon les revendications 3 et 4, caractérisée en ce que le composé générateur d'acide comporte un groupement acétyle chloré ou bromé.

6. Composition travaillant en positif selon la revendication 1, caractérisée en ce que le composé générateur d'acide comporte un groupe tert-butyle chloré ou bromé.

7. Composition travaillant en positif selon la revendication 1, caractérisée en ce que le composé générateur d'acide ne comporte pas d'atomes d'hydrogène en position *trans* par rapport à l'atome de chlore ou de brome, sur l'atome de carbone en position α par rapport à l'atome de carbone substitué par un halogène.

8. Composition travaillant en positif selon la revendication 1, caractérisée en ce que le composé générateur d'acide, en plus des atomes de chlore ou de brome liés à un radical aliphatique, comporte également des atomes d'halogène liés à un radical aromatique.

9. Composition travaillant en positif selon la revendication 8, caractérisée en ce que les atomes de chlore ou de brome liés à un radical aromatique sont en position ortho par rapport à un groupe OH phénolique.

10. Composition travaillant en positif selon la revendication 1, caractérisée en ce que le substituant contenant un atome de chlore ou de brome lié à un radical aliphatique est lié une ou plusieurs fois à un polymère soluble dans une solution alcaline.

11. Composition travaillant en positif selon une ou plusieurs des revendications 1 à 10, caractérisée en ce que la composition contient en outre un liant soluble dans une solution alcaline.

12. Matériau de reproduction travaillant en positif, essentiellement constitué d'un support et d'une couche sensible aux radiations, caractérisé en ce que la couche consiste en une composition durcissable par irradiation, selon une ou plusieurs des revendications 1 à 11.

13. Procédé pour l'enregistrement d'un rayonnement à haute énergie, à l'aide du matériau de reprographie travaillant en positif selon la revendication 12, caractérisé en ce qu'une composition durcissable par irradiation, selon le srevendications 1 à 11, est appliquée sur un support éventuellement revêtu d'un agent favorisant l'adhérence, le matériau est séché, puis irradié selon l'image avec un rayonnement riche en énergie, en particulier des rayons X ou un faisceau d'électrons, ou un un rayonnement UV à courte longueur d'onde, après cela éventuellement traité thermiquement à haute température, et finalement l'image est développée par élimination des zones non irradiées de la couche, à l'aide d'un révélateur aqueux-alcalin.
